# EUROPEAN PATENT APPLICATION

(11) **EP 4 660 864 A1**
(43) Date of publication of application: **10.12.2025**
(21) Application number: 24180474.9
(22) Date of filing: 06.06.2024
(51) Int. Cl.: G06F 30/13, G06N 20/00, G06Q 50/16

(54) **METHOD FOR ASSESSING A FEEDBACK ON AN INFORMATION MODEL OF A BUILDING**

(71) Applicant: ABB SCHWEIZ AG, 5400 Baden (CH)
(72) Inventor: BORRISON, Reuben, 68782 Brühl (DE); ALEKSY, Markus, 67065 Ludwigshafen (DE); DIX, Marcel, 78476 Allensbach (DE)
(74) Representative: Maiwald GmbH

(57) **Abstract**

A computer implemented method for assessing a feedback of an information model of a building, comprising: receiving raw data of a building; generating an information model of a building based on the raw data; receiving a feedback of a user for the generated information model; assessing the received feedback and determining an assessing result; providing the assessing result for further processing.

## Description

### FIELD OF INVENTION

The present invention relates to a computer-implemented method for assessing a feedback on an information model of a building, to a data processing device, to a computer program and to a computer readable medium.

### BACKGROUND OF THE INVENTION

Information models are widely used for describing a behaviour of a system. The system may be for example be a house. Such an information model of a building is well known in the state of the art. However, such an information model of a building has to be trained. Such a training is crucial for a reliability and accuracy of such an information model of a building. Such a training comprises a feedback on such a generated or trained information model.

It has now become apparent that there is a further need to provide a possibility to assess such a training of an information model of a building.

### SUMMARY OF THE INVENTION

In view of the above, it is an object of the present invention to provide a method for assessing a feedback on a prediction of an information model of a building, in particular it is an object of the present invention to provide an improved method for assessing a feedback on a prediction of an information model of a building.

In one aspect of the present disclosure, a computer implemented method for assessing a feedback on an information model of a building is provided, comprising:
receiving raw data of a building;
generating based on the raw data an information model of the building;
receiving a feedback of a user for the generated information model;
assessing the received feedback and determining an assessing result;
providing the assessing result for further processing.

In an embodiment of the method, the feedback may comprise at least one of the following: a change of a label, a change of relation between different entities of the information model of the building, a highlighting of a part of the information model of the building.

In an embodiment of the method, the information model may be a standard information model.

In an embodiment of the method, the information model may be generated by at least one of the following: generative AI model, ML model, a large language model.

In an embodiment of the method, the assessing of the feedback may comprise a search for a contradiction.

In an embodiment of the method, the assessing of the feedback may comprise a comparison of the feedback of the user with historical feedback.

In an embodiment of the method, the assessing result may comprise at least two values.

In an embodiment of the method, the further processing may comprise
in case the assessing result is positive, implementing the feedback of the user into the information model;
in case the assessing result is negative, rejecting the feedback of the user or asking for additional feedback of the user.

In an embodiment of the method, the asking for additional feedback may comprise a checking of a reliability of the feedback of the user.

In an embodiment of the method, based on the additional feedback the feedback of the user may be either implemented into the information model or rejected.

A further aspect relates to a data processing device comprising means for carrying out the method described above.

A further aspect relates to a computer program comprising instructions, which, when the program is executed by a processor, cause the processor to carry out the method described above. The processor can typically be part of a computer.

A further aspect relates to a non-transitory computer-readable storage medium comprising instructions, which, when executed by a processor, cause the processor to carry out the method described above.

### DEFINITIONS

The term feedback of a user, as used herein, is to be understood broadly and may relate to an assessment of a user on an information model of a building. The feedback may comprise an adaption of the information model in order to correct information. The feedback of the user preferably may relate to a current feedback of a user. The feedback may be given on a part of the information model where the user sees an error of the information model. The feedback may be received by a user interface, for example a HMI, a touchscreen, a computer mouse it easy. The feedback may comprise an approval of an information model, in particular at least a part of the information model.

The term information model, as used herein, is to be understood broadly and may relate to a model describing for a building a relation between input data and output data. The information model may describe a relation between entities of a building. The relation may for example comprise that a sensor x is located in a room y and provides a temperature value. The information model may describe a behaviour of a building. The information model may describe a structure, a layout, or a configuration of one or more entities of a building in the information model of the building.

The term building, as used herein, is to be understood broadly and may relate to one or more of the following: flat, house, plant.

The term raw data, as used herein, is to be understood broadly and may relate to one or more of the following: number of rooms, space of a room, temperature of a room, humidity of a room, air condition system, sensor device (e.g., temperature, humidity). The raw data may be part of the input data for the information model.

The term entity, as used herein, is to be understood broadly and may relate to a sub unit of a building. An entity may be a room, sensor, a heater, light, a climate system, water pipe, a window, a door, or blinds.

The term assessing result, as used herein, is to be understood broadly and may relate to an assessment of the feedback of the user. The assessing result may comprise a value, a statement, a colour, or any other coding configured to distinguish between positive and negative. The assessing result may relate to a text, e.g. contradiction and no contradiction.

The term label, as used herein, may relate to an informative tag of an entity or a relation between at least two entities. For example, an entity is labelled as temperature sensor. For example, a relation between a temperature sensor and a room is labelled as the temperature sensor is positioned in the room.

The term relation, as used herein, may relate to an assignment of an entity to one or more other entities.

The term highlighting a part of a building, as used herein, may relate to a selection of a part of a building in order to indicate that this part is not correct.

The term standard information model, as used herein, may relate to a digital representation of a building according to the standard of the Brick schema. The term Brick, as used herein, relates to a state of the art standardized description of physical, logical and virtual entities in a building and relationships between them. The standard information model may process building management system (BMS) metadata. The standard information model may be based on BMS metadata.

The term generative AI model, used herein, may relate to a type of artificial intelligence (Al) system that may have the ability to generate new data or content that is similar to, but not exactly the same as, the data it was trained on. A generative AI model may be capable of creating new content (e.g. description of a building) based on patterns and structures learned from a dataset during the training process. The generative AI models may be one of the following: Generative Adversarial Network (GAN), Variational Autoencoders (VAE), and autoregressive models like OpenAI's GPT series.

The term ML model, as used herein, may relate to a machine learning (ML) model. The machine learning model may relate to a mathematical representation of patterns and relationships in data, constructed using algorithms. The ML model may be trained on input data to make predictions or decisions without being explicitly programmed to perform the task. The training process may involve feeding the ML model with labelled data (input-output pairs), allowing it to learn the underlying patterns and associations.

The term large language model (LLM), as used herein, may relate to a type of machine learning model specifically designed to understand and generate human-like text.

The term contradiction, as used herein, may preferably relate to a contradiction of a feedback from the user (i.e. current feedback) with a historical feedback from the user (i.e. previous feedback). For example, one time a user labels an entity as a sensor and the next time the user labels the same type of entity as a heater.

The term historical feedback, as used herein, is to be understood broadly and may relate to previous feedback of the same user or another user. The historical feedback may be stored in a database. The comparison of historical feedback with the feedback of the user (i.e. current feedback) may reveal contradictions. The historical feedback may relate to same or similar raw data that was labelled differently and was accepted or changed by the user.

The term additional feedback, as used herein, is to be understood broadly and may relate to feedback of a user after a feedback of the user (i.e. current feedback) lead to a negative assessing result. The additional feedback may enable an additional assessing of the feedback of the user (i.e. current feedback) on a same or similar raw data in order to check a reliability of the user or the feedback of the user. The additional feedback may be accompanied by a question regarding a conviction of the user to the feedback and/or the additional feedback.

The checking of the reliability may comprise a question whether the user was sure about his feedback (i.e. current feedback, previous/historical feedback and/or additional feedback).

Units and/or devices according to one or more example embodiments may be implemented using hardware, software, and/or a combination thereof. For example, hardware devices may be implemented using processing circuitry such as, but not limited to, a processor, Central Processing Unit (CPU), a controller, an arithmetic logic unit (ALU), a digital signal processor, a microcomputer, a field programmable gate array (FPGA), a System-on-Chip (SoC), a programmable logic unit, a microprocessor, or any other device capable of responding to and executing instructions in a defined manner.

Units or devices may include one or more interface circuits. In some examples, the interface circuits may include wired or wireless interfaces that are connected to a local area network (LAN), the Internet, a wide area network (WAN), or combinations thereof. The functionality of any given device or unit of the present disclosure may be distributed among multiple units or devices that are connected via interface circuits.

Devices according to one or more example embodiments may also include one or more storage devices. The one or more storage devices may be tangible or non-transitory computer-readable storage media, such as random access memory (RAM), read only memory (ROM), a permanent mass storage device (such as a disk drive), solid state (e.g., NAND flash) device, and/or any other like data storage mechanism capable of storing and recording data. The one or more storage devices may be configured to store computer programs, program code, instructions, or some combination thereof.

Any disclosure and embodiments described herein relate to the methods, the devices, the computer program and computer-readable medium lined out above and vice versa. Advantageously, the benefits provided by any of the embodiments and examples equally apply to all other embodiments and examples and vice versa.

As used herein "determining" also includes "initiating or causing to determine", "generating" also includes "initiating or causing to generate" and "providing" also includes "initiating or causing to determine, generate, select, send or receive". "initiating or causing to perform an action" includes any processing signal that triggers a computing device to perform the respective action.

### BRIEF DESCRIPTION OF THE DRAWINGS

In the following, the present disclosure is described exemplarily with reference signs to the enclosed figures, in which
- **Figure 1**: shows a flow diagram of an example method for assessing feedback on an information model of a building; and
- **Figure 2**: shows a schematic illustration of an example system for assessing feedback on an information model of a building.

### DETAILED DESCRIPTION OF EMBODIMENTS

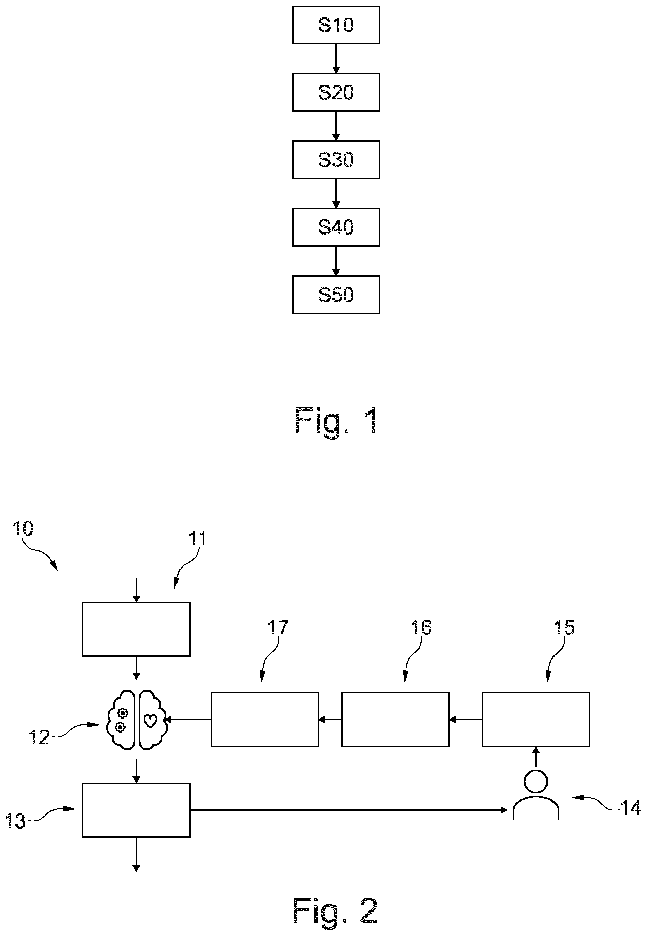

Figure 1 shows a flow diagram of an example method for assessing a feedback on an information model of a building.

Step S 10 comprises receiving raw data of a building. The building may be in the present example an office building with one or more of the following entities: a plurality of rooms, temperature sensors, humidity sensors, heaters, climate systems. The raw data may relate in the present example to the aforementioned entities. The raw data may be received by means of an interface for data exchange. The raw data may comprise the form of BMS metadata.

Step S 20 comprises generating an information model of a building based on the raw data. The information model may be in the present example a standard information model. The standard information model may be based in the present example on the Brick schema and BMS metadata. The information model may be generated by a large learning model. The information model may be in the present example a partly trained model that has to be optimized and/or finally trained. The information model may alternatively be in an initial training state and has to be trained with the raw data for the first time. The information model may alternatively already be in use and is trained further in order to evolve or optimize the information model.

Step S 30 comprises receiving the feedback of a user for the determined prediction. The generated information model may be presented to a user for example on a display. The feedback may be received by means of an HMI or any other user interface. The feedback may comprise a highlighting of a part of the prediction, a change of a label of the prediction, and/or a change of a relation between the one or more entities.

Step S 40 comprises assessing the received feedback and determining an assessing result. The assessing may comprise in the present example a search for a contradiction. The contradiction may be determined by a comparison of the feedback of the user with historical feedback for the same or similar raw data. The assessing result is in the present example either positive or negative.

Step S 50 comprises providing the assessing result for further processing. The further processing may comprise in the present example in case the assessing result is positive, implementing the feedback of the user into the information model, in case the assessing result is negative, rejecting the feedback of the user or asking for additional feedback from the user. Implementing the feedback may comprise overwriting/changing an earlier feedback.

Figure 2 shows a schematic illustration of a workflow 10 for assessing feedback on an information model of a building.

The workflow 10 comprises a LLM 12 for generating a standard information model 13 for a building. The LLM 12 receives raw data 11, in particular BMS metadata, as input data. The LLM 12 provides the trained information model 13. The information model 13 is presented to a user 14, for example on a display. The user 14 provides then feedback 15 on the information model 13. Additionally, historical feedback 16 for same or similar raw data are provided. A validator 17 assess the feedback 15 by comparing it with the historical feedback 16 and determines an assessing result. In case the assessing result is positive, the feedback is fed into the LLM 12 for training the information model 13 otherwise it is rejected.

In other words, the workflow may start with some raw building data 11 that would be converted into a standard information model (IM) 13, such as BRICK schema.

The raw data 11 may be given to an LLM 12, such as ChatGPT, with the request to convert it into the IM format.

The generated IM 13 is presented to the user 14 if the result looks satisfactory or needs corrections.

The user 14 may give feedback 15 on the IM 13, by highlighting what parts of the generated IM are not correct in his/her view.

A validator 17 may check if this feedback 15 contradicts with earlier feedback 16 given by the user. For this, the proposed system 10 may need to track the history of earlier feedback.

Contradictions can be determined, e.g., if the feedback given by the user seems to "lead anywhere or if the user feedback (i.e. feedback of the user) is just going around in circles". For this, the validator could check, e.g. if the user makes a correction which he has already corrected previously in a different way. If the resulting information model looks again like in the beginning so that all the changes that were proposed by the user were once added but then removed again. Hence, the validator works always by "comparing". It does not require any built-in expert rules but simply reasons by identifying contradictions to previous feedback.

In the following, a summary of the main effects and main advantages of the present disclosure is provided:
This invention may describe a method/system to identify that user feedback on model predictions may be incorrect. Consequently, the proposed method/system would be also capable of filtering out that user feedback that was not correct. The proposed method/system may be specifically designed for the use case of assessing building information models that have been generated by a large language model (LLM).

Machine learning (ML) models can make wrong predictions, which is why feedback from a user is needed to give correct labels for predictions. The problem is that also the user feedback can be wrong: The user may give feedback which does not improve the model predictions but makes them worse. This invention relates to a method/system how to assess if the user feedback seems to be wrong.

Similar to an interrogation of a suspect, the method may check if the user seems to get caught in contradictions with respect to his/her feedback given so far. For this the method may keep a record of his/her feedback (i.e. historical feedback). The method may check to what extent is new feedback given free from contractions.

The method may specifically be designed to the problem of converting raw building data to a standard building information model, such as BRICK, using ML, particularly using a large language model (LLM) such as ChatGPT. The user feedback may be given to highlighted parts in the generated information model where the user sees an error. This can be, e.g., in the form of marking entities or links in the information model and giving them a different label, or suggesting different links between entities by drawing a different connection between them.

User feedback may not be asked for only once, but over and over again, in an iterative loop, until the information model is acceptable by the user. The method may keep asking the user in each loop if the information model seems acceptable, or to give feedback what still needs to be corrected. Hence, the user may have the possibility to give more feedback on the information model. If that additional user feedback (i.e. additional feedback of the user) seems to contradict with earlier feedback (i.e. historical feedback of the user), this would be a measure to tell if the user is giving his/her feedback in confidence or not.

### REFERENCE SIGNS

- S10: receiving raw data
- S20: generating an information model
- S30: receiving a feedback
- S40: assessing the feedback and determining an assessing result
- S50: providing the assessing result

- 10: workflow
- 11: raw data
- 12: LLM
- 13: information model
- 14: user
- 15: feedback
- 16: historical feedback
- 17: validator

## Claims

1. A computer implemented method for assessing a feedback of an information model of a building, comprising:
receiving raw data of a building;
generating an information model of a building based on the raw data;
receiving a feedback of a user for the generated information model;
assessing the received feedback and determining an assessing result;
providing the assessing result for further processing.

2. The method according to claim 1, wherein the feedback comprises at least one of the following: a change of a label, a change of relation between different entities of the information model of the building, a highlighting of a part of the information model of the building.

3. The method according to claim 1 or 2, wherein the information model is a standard information model.

4. The method according to any one of the preceding claims, wherein the information model of the building is generated by at least one of the following: generative AI model, machine learning model, a large language model.

5. The method according to any one of the preceding claims, wherein the assessing of the feedback of the user comprises a search for a contradiction.

6. The method according to any one of the preceding claims, wherein the assessing of the feedback of the user comprises a comparison of the feedback of the user with historical feedback.

7. The method according to any one of the preceding claims, wherein the assessing result comprises at least two values.

8. The method according to any one of the preceding claims, wherein the further processing comprises
in case the assessing result is positive, implementing the feedback of the user into the information model of the building;
in case the assessing result is negative, rejecting the feedback of the user or asking for additional feedback of the user.

9. The method according to any one of the preceding claims, wherein the asking for additional feedback of the user comprises a checking of a reliability of the feedback of the user.

10. The method according to any one of the preceding claims, wherein based on the additional feedback of the user, the feedback of the user is either implemented into the information model of the building or rejected.

11. A data processing device comprising means for carrying out the method according to any one of the claims 1 to 10.

12. A computer program comprising instructions, which, when the program is executed by a processor, cause the processor to carry out the method according to any one of the claims 1 to 10.

13. A non-transitory computer-readable storage medium comprising instructions which, when executed by a processor, cause the processor to carry out the method according to any one of the claims 1 to 10.
